# EUROPÄISCHE PATENTSCHRIFT

(11) **EP 0 898 350 B1**
(45) Veröffentlichungstag und Bekanntmachung des Hinweises auf die Patenterteilung: **17.11.2004**
(21) Anmeldenummer: 98112572.7
(22) Anmeldetag: 07.07.1998
(51) Int. Cl.: H02H 3/14, G01R 27/18, B25F 5/00, G01V 3/15

(54) **Schaltung zur Erkennung eines geerdeten Metallteiles**
Circuit for detecting an earthed metallic element
Circuit pour détecter un élément métallique raccordé à la terre

(30) Priorität: 18.08.1997 DE 29714759 U
(43) Veröffentlichungstag der Anmeldung: 24.02.1999
(73) Patentinhaber: HEINRICH KOPP AG, D-63796 Kahl am Main (DE)
(72) Erfinder: Fleckenstein, Hans-Jürgen, 63776 Schimborn (DE); Holscher, Norbert, 63636 Brachttal (DE)
(74) Vertreter: Reinhard - Skuhra - Weise & Partner

(56) Entgegenhaltungen:
- DE-A- 3 235 194
- DE-A- 3 504 056
- US-A- 4 650 375
- PATENT ABSTRACTS OF JAPAN vol. 095, no. 003, 28. April 1995 & JP 06 335812 A (HITACHI BUILDING SYST ENG & SERVICE CO LTD), 6. Dezember 1994

## Beschreibung

Die Erfindung betrifft eine Schaltung zur Erkennung eines geerdeten Metallteils, insbesondere für handgeführte, elektrisch betriebene Maschinen, wie Bohrmaschinen oder dergleichen.

Beim Anbohren eines Wasser- oder Gasrohres aus Metall können derartige Rohre beschädigt werden, was größere Folgeschäden mit sich bringen kann. Um ein Anbohren von beispielsweise Wasseroder Gasrohren zu verhindern, werden in zunehmendem Maße Maschinen, insbesondere elektrisch betriebene Maschinen wie Bohrmaschinen oder dergleichen Einrichtungen vorgeschaltet, welche die Maschine abschaltet, sobald das in die Maschine eingesetzte Werkzeug, beispielsweise der Bohrer, mit geerdeten Metallteilen in Berührung gelangt. Voraussetzung für das Erkennen eines Metallteiles ist, daß die gefährdeten Metallteile eine hinreichende Verbindung zum Potentialausgleich besitzen.

Eine Schaltung zur Erkennung eines geerdeten Metallteiles, auch Schaltung für eine Metalltreffer-Erkennung genannt, enthält einen Transformator, der eine Hilfsspannung erzeugt, die auf das Werkzeug bzw. die Maschine gelegt wird. Als Referenz für diese Hilfsspannung dient der Schutzleiter. Bei dieser Schaltung wird die Hilfsspannung über den Schutzleiteranschluß der Maschine dem Werkzeug zugeführt. Zur Unterbrechung der Spannung, mit welcher die Maschine versorgt wird, dient ein konventionelles Relais, welches entsprechend leistungsfähig sein muß. Demzufolge ist ein relativ hoher Spulenstrom durch den Transformator zu erzeugen, um das Relais im Falle einer Erkennung eines Metallteiles zu schalten bzw. anziehen zu lassen. Mit Hilfe das Relais werden die Kontakte in den Speiseleitungen zur Maschine unterbrochen.
Um einen derart hohen Spulenstrom zu erzeugen, ist ein relativ großer Transformator erforderlich, wodurch die Schaltung insgesamt nachteiligerweise ein relativ großes Gehäuse erforderlich macht. Ein Nachteil der bekannten Schaltung besteht darin, daß ihr Einsatz bei portablen Werkzeugen bzw. Maschinen durch die Verwendung eines großen Gehäuses einschließlich eines relativ großen Transformators die Handhabung einer solchen Maschine stört und deren Gewicht erhöht.

DE 35 04 056 A offenbart eine Schaltung zur Erkennung eines geerdeten Metallteiles oder dergleichen, für eine elektrisch betriebene Bohrmaschine mit einem Meßverstärker (7), der Eingänge für die Betriebsspannung (über einen Transformator) und Masse aufweist, wobei der Meßverstärker (7) im Falle einer Feststellung eines geerdeten Metaliteiles ein Ausgangssignal erzeugt, welches ein Steuersignal zur Spannungsunterbrechung der Maschine erzeugt.

Der Erfindung liegt die Aufgabe zugrunde, eine Schaltung der eingangs genannten Art zu schaffen, die sich bei tragbaren Maschinen einsetzen läßt ohne maßgebliche Erhöhung deren Gewichts und die darüberhinaus bei einem Kurzschluß zwischen einer Phase und dem Werkzeug, z.B. durch einen Defekt in der Maschine oder beim Auftreffen auf eine Fremdphase, keiner Zerstörung ausgesetzt wird.

Diese Aufgabe wird erfindungsgemäß durch die im Patentanspruch 1 angegebenen Merkmale gelöst.

Weitere Ausgestaltungen der Schaltung ergeben sich aus den Unteransprüchen.

Die Erfindung schafft eine Schaltung zur Erkennung eines geerdeten Metallteiles, insbesondere zur Verwendung in handgeführten, elektrisch betriebenen Maschinen wie Bohrmaschinen oder dergleichen, die beim Auftreffen auf ein Metallteil den Betrieb der Maschine unterbricht. Die erfindungsgemäße Schaltung erfordert keine Verwendung eines Transformators und ist somit sowohl von der Größe her als auch vom Gewicht gegenüber dem Gewicht einer üblichen Werkzeugmaschine, beispielsweise Bohrmaschine, vernachlässigbar. Die erfindungsgemäße Schaltung wird auch im Falle eines Kurzschlusses zwischen einer Phase und dem Werkzeug, z.B. durch einen Defekt in der Maschine oder beim Auftreffen auf eine Fremdphase nicht zerstört.

Die erfindungsgemäße Schaltung läßt sich vorteilhafterweise in portablen Maschinen bzw. Werkzeugen einsetzen und wird in die Zuleitung der Maschine eingefügt, was aufgrund ihrer handlichen Abmessungen möglich ist. Vorteilhafterweise läßt sich die erfindungsgemäße Schaltung auch mit einem Differenzstromauslöser bzw. Fehlerstromschutzschalter kombinieren, so daß die Maschine auch bei Auftreten eines Fehlerstromes automatisch abgeschaltet wird.

Im folgenden wird die erfindungsgemäße Schaltung anhand der Zeichnung zur Erläuterung weiterer Merkmale beschrieben. Es zeigen:
- Figur 1: das Schaltbild einer bevorzugten Ausführungsform der erfindungsgemäßen Schaltung, und
- Figur 2: eine schematische Darstellung der erfindungsgemäßen Schaltung nach Figur 1 in Verbindung mit einem Fehlerstromschutzschalter.

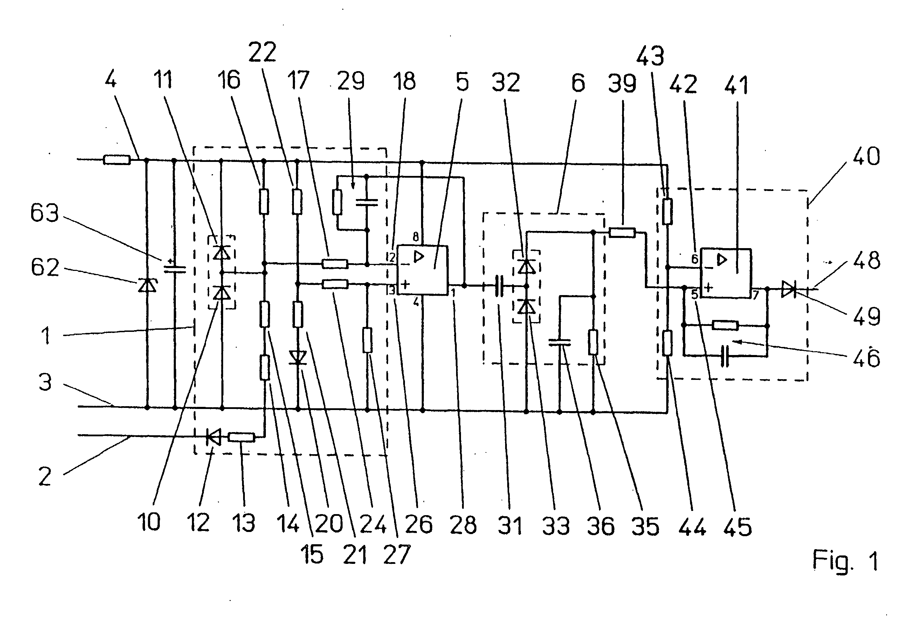

Figur 1 zeigt ein schematisches Schaltbild der erfindungsgemäßen Schaltung zur Erkennung eines geerdeten Metallteiles, d.h. einer Schaltung zur Metalltreffer-Erkennung. Diese Schaltung wird nachfolgend zur Erläuterung der prinzipiellen Funktionsweise beschrieben.

Gemäß Figur 1 besteht die erfindungsgemäße Schaltung aus einem Meßverstärker 1, der einen Sensoreingang 2 aufweist, sowie einem Eingang 3 und einem Eingang 4 zur Spannungsversorgung. Der Eingang 3 liegt auf Null Volt und der Eingang 4 auf dem Wert der Speisespannung. Der Meßverstärker 1 ist an einen Operationsverstärker 5 angeschlossen, welcher seinerseits ausgangsseitig an eine Ladungspumpe 6 angeschlossen ist, die zur Gleichrichtung des Ausgangssignales des Meßverstärkers 1 bzw. des Operationsverstärkers 5 dient. Der Ausgang der Ladungspumpe 6 ist an einen Komparator 40 geschaltet, der seinerseits als Ausgangssignal ein Steuersignal erzeugt abhängig davon, daß am Sensoreingang 2 ein geerdetes Metallteil ermittelt wurde.

Der Meßverstärker 1 weist zwischen den Eingängen 3 und 4 zwei in Serie geschaltete Dioden 10, 11 auf, die als Spannungsbegrenzer wirken. Weiterhin ist am Sensoreingang eine Diode 12 vorgesehen, die den Spannungswert am Sensoreingang 2 begrenzt und über Widerstände 13, 14, 15, 16 an die Leitung 4 geschaltet ist. Zwischen den Widerständen 15 und 16 einerseits und den Dioden 10, 11 andererseits befindet sich eine Verbindung. Die Verbindungsleitung zwischen den Widerständen 15, 16 ist über einen weiteren Widerstand 17 an einen invertierenden Eingang 18 des Operationsverstärkers 5 angeschlossen. Parallel zu den Dioden 10, 11 ist eine Serienschaltung aus einer Diode 20, Widerstand 21 und Widerstand 22 zwischen die Leitungen 3, 4 geschaltet. Eine Verbindungsleitung zwischen den Widerständen 21 und 22 ist über einen Widerstand 24 an den nicht-invertierenden Eingang 26 des Operationsverstärkers 5 geschaltet, wobei der Eingang 26 über einen Widerstand 27 mit der Leitung 3 verbunden ist. Schließlich befindet sich zwischen dem mit 28 bezeichneten Ausgang des Operationsverstärkers 5 und dem invertierenden Eingang 18 des Operationsverstärkers 5 eine aus einem RC-Glied bestehende Rückkopplung, die mit 29 bezeichnet ist.

Bezüglich der Schaltung der Dioden 10 bis 12 und 20 wird ausdrücklich auf Figur 1 verwiesen, aus der die Polung der Dioden hervorgeht.

Der Meßverstärker 1 erzeugt ausgangsseitig des Operationsverstärkers 5 ein periodisches Signal mit Netzfrequenz, wenn am Sensoreingang 2 ein Metalltreffer, d.h. ein geerdetes Metallteil festgestellt wird, wobei die Signalamplitude dieses periodischen Signals vom Übergangswiderstand zu dem ermittelten Metallteil (Sensoreingang 2) abhängt. Je kleiner der Übergangswiderstand ist, umso größer ist die Amplitude des periodischen Signals.

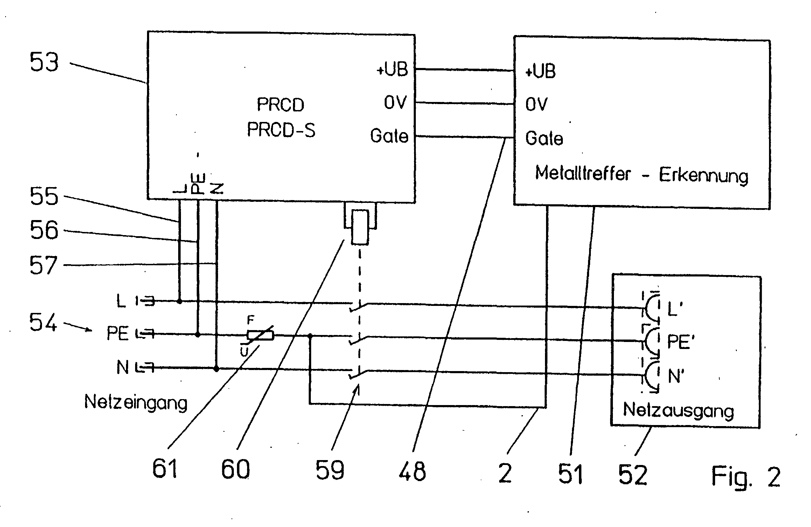

Die Dioden 12 und 10, 11 begrenzen die Spannung am invertierenden Eingang 26 zum Operationsverstärker derart, daß sie keine unzulässigen Werte annehmen kann. Die Widerstände 13, 14, 15, mit welchen der Sensoreingang 2 beschaltet ist, sind so ausgelegt, daß der Strom über den PE-Anschluß (PE'maschinenseitig gemäß Figur 2) entsprechend den Vorschriften nicht überschritten wird.

Die Diode 20 dient der Kompensation des Temperaturganges der vor dem Widerstand 13 liegenden Diode 12.

Das Ausgangssignal des Komparators 5 wird durch die nachgeschaltete Ladungspumpe 6 gleichgerichtet. Die Ladungspumpe 6 weist eingangsseitig einen Kondensator 31 auf, der über eine Diode 32 mit dem Ausgang der Ladungspumpe 6 verbunden ist, weiterhin über eine Diode 33 gegen die Leitung 3 liegt. Weiterhin ist der Ausgang der Ladungspumpe 6 über einen Widerstand 35 und einen Kondensator 36 mit der Leitung 3 verbunden. Der Ausgang der Ladungspumpe 6 ist über einen Widerstand 39 mit einem Komparator 40 verbunden, dessen zweiter Eingang durch die Leitung 4 repräsentiert ist.

Der Komparator 40 enthält einen Operationsverstärker 41, dessen invertierender Eingang 42 über einen Widerstand 43 an die Leitung 4 geschaltet ist sowie über einen Widerstand 44 an die Leitung 3. Der nicht invertierende Eingang 45 des Operationsverstärkers 41 ist mit dem Ausgang der Ladungspumpe 6 verbunden. Zwischen dem nicht-invertierenden Eingang 45 und dem Ausgang des Operationsverstärkers 41 befindet sich ein RC-Glied 46. Das Ausgangssignal des Komparators 40 ist mit 48 bezeichnet.

Das Ausgangssignal der Ladungspumpe 6 wird somit dem Komparator 46 zugeführt. Überschreitet die Spannung am nicht-invertierenden Eingang 45 die am invertierenden Eingang 42 liegende Referenzspannung, dann erzeugt der Operationsverstärker 41 des Komparators 40 eine Spannung, die über eine Diode 49 zum Ausgang 48 geführt wird. Dieses Ausgangssignal wird zum Abschalten der Maschine verwendet, beispielsweise zum Öffnen von Schaltkontakten im Speisekreis der Maschine, wie dies nachfolgend in Verbindung mit Figur 2 beschrieben wird. Die Polung der Dioden 32, 33 und 49 ergibt sich aus der Darstellung von Figur 1.

Vorzugsweise ist der Ausgang 48 mit dem Gate eines in Figur 1 nicht dargestellten Thyristors verbunden, so daß im Falle eines Ausgangssignales am Ausgang 48 der Thyristor gezündet wird und die noch zu beschreibenden Schaltkontakte, über welche die Maschine mit dem Netz verbunden ist, zum Abschalten der Maschine geöffnet werden.

Die Diode 49 dient bei der dargestellten Schaltung dazu, eine Zündung des Thyristors aus einem Fehlerstromschutzschalter zu ermöglichen, da im Ruhezustand der Ausgang des Operationsverstärkers 40 auf Null Volt liegt.

Figur 2 zeigt die erfindungsgemäße Schaltung, die mit 51 bezeichnet ist, in Verbindung mit der durch die Schaltung 51 gesteuerten Maschine 52 und einem Fehlerstromschutzschalter 53. Gemäß Figur 2 ist der Fehlerstromschutzschalter 53 hinter dem Netzeingang, beispielsweise in Form eines Steckers, angeschlossen, der in Figur 2 durch das Bezugszeichen 54 angedeutet ist. Die entsprechenden Leitungen sind mit L, PE, N bezeichnet und über Leitungen 55, 56, 57 an den Fehlerstromschutzschalter 53 angeschaltet. Die durch den Fehlerstromschutzschalter 53 gesteuerten Schaltkontakte sind durch das Bezugszeichen 59 bezeichnet und werden über ein Relais 60 oder dergleichen gesteuert, welches seinerseits durch den Fehlerstromschutzschalter 53 angesteuert wird. Zwischen dem Netzeingang PE und dem maschinenseitigen Anschluß PE' befindet sich ein Bauteil 61, vorzugsweise ein Varistor, der das Anlegen der Prüfspannung auf das Gehäuse der Maschine 52 bzw. deren Werkzeug ermöglicht. Dieses Bauteil 61 ist im Normalbetrieb hochohmig und im Falle einer Verbindung zu einer Phase wird es niederohmig. Durch dieses Bauteil 61 wird die die Maschine 52 bedienende Person beim Auftreffen auf eine Fremdphase oder bei einem Defekt innerhalb der Maschine vor Spannung geschützt. Der Varistor 61 hat vorzugsweise eine niedrige Varistorspannung. Ersichtlicherweise können anstelle eines Varistors auch andere Bauteile oder elektronische Baugruppen verwendet werden, die ein entsprechendes Verhalten aufweisen. Dabei muß auf ein ausreichendes Schaltvermögen geachtet werden, damit bei einem Auftreffen auf eine Phase das Bauteil 61 bzw. die entsprechende Baugruppe nicht zerstört wird und der Schutz der die Maschine 52 bedienenden Person bestehen bleibt.

Gemäß Figur 2 ist die erfindungsgemäße Schaltung über ihren Sensoranschluß 2 an die Verbindung zwischen dem Bauteil 61 und dem maschinenseitigen Anschluß PE' angeschlossen, wobei der Schaltkontakt 59 hinter der Verbindung des Sensoreinganges 2 mit dem Bauteil 61 vorgesehen sind. Die Schaltkontakte 59 befinden sich damit in dem Verbindungsleitungen zwischen der Maschine 52 und den Anschlüssen zum Fehlerstromschutzschalter 53, wie Figur- 2-deutlich zeigt.

Bei Einsatz der erfindungsgemäßen Schaltung 51 in Verbindung mit einem Fehlerstromschutzschalter 53 wird bei Erkennung eines Metallteiles, d.h. wenn z.B. eine Bohrmaschine 52 auf ein Metallrohr auftritt und die Erdung über den maschinenseitigen Ausgang PE' und den Sensor 2 an die Schaltung gemeldet wird, erreicht, daß die Schaltung 51 über den Ausgang 48 ein Signal z.B. an das Gate des nicht dargestellten Thyristors liefert, der die Fehlerstromschutzschaltung 53 aktiviert, um die Schaltkontakte 59 zu öffnen. Vorteilhafterweise wird in Bezug auf die Schaltung nach Figur 2 erreicht, daß auch ein Differenzstrom, d.h. ein Fehlerstrom unabhängig von der Erkennung eines Metallteiles dazu führt, daß der Fehlerstromschutzschalter 53 angesteuert wird zum Öffnen der Schaltkontakte 59 und auch auf diese Weise die Maschine 52 vom Stromkreis getrennt wird. Somit arbeitet die in Figur 2 gezeigte Schaltung auch dann zur Erhöhung der Betriebssicherheit, wenn ohne Metalltreffer-Erkennung ein Fehlerstrom erfaßt wird und die Abschaltung der Maschine 52 durch Öffnen der Schaltkontakte 59 ausgeführt wird.

Zur Spannungsbegrenzung sind eingangsseitig des Meßverstärkers 1 eine Zenerdiode 62 und eine Kapazität 63 vorgesehen, die zueinander parallel geschaltet sind.

## Patentansprüche

1. Schaltung zur Erkennung eines geerdeten Metallteiles oder dergleichen, insbesondere für handgeführte, elektrisch betriebene Maschinen wie Bohrmaschinen oder dergleichen, mit einem Meßverstärker (1), der Eingänge (4, 3) für die Betriebsspannung und Masse sowie einen Eingang (2) für ein Schutzleiterpotential aufweist,
mit einem an den Meßverstärker (1) angeschlossenen Operationsverstärker (5), der im Falle einer Feststellung eines geerdeten Metallteiles ein Ausgangssignal erzeugt, welches an eine Ladungspumpe (6) zur Spannungsbegrenzung angelegt wird,
wobei die Ladungspumpe (6) mit einem Komparator (40) verbunden ist, dessen Ausgang im Falle der Feststellung eines geerdeten Metallteiles ein Steuersignal zur Spannungsunterbrechung der Maschine erzeugt.

2. Schaltung nach Anspruch 1,
**dadurch gekennzeichnet,**
**daß** das Ausgangssignal des Operationsverstärkers (1) ein periodisches Signal mit Netzfrequenz ist.

3. Schaltung nach Anspruch 1 oder 2,
**dadurch gekennzeichnet,**
**daß** der Meßverstärker (1) eine Einrichtung (10, 11) zur Begrenzung der Eingangsspannung aufweist.

4. Schaltung nach Anspruch 1 oder 2,
**dadurch gekennzeichnet,**
**daß** der Meßverstärker (1) eine Einrichtung (12) zur Begrenzung der über den Sensoreingang (2) zugeführten Eingangsspannung aufweist.

5. Schaltung nach einem der vorangehenden Ansprüche,
**dadurch gekennzeichnet,**
**daß** die Ladungspumpe (6) mit einer Einrichtung (32, 33) zur Gleichrichtung des Eingangssignals zur Ladungspumpe (6) versehen ist.

6. Schaltung nach wenigstens einem der vorangehenden Ansprüche,
**dadurch gekennzeichnet,**
**daß** der Ausgang des Komparators (40) an einen Fehlerstromschutzschalter (53) angeschlossen ist, welcher zwischen der Maschine (52) und dem Netzeingang (54) liegende Schaltkontakte (59) steuert.

7. Schaltung nach Anspruch 6,
**dadurch gekennzeichnet,**
**daß** zwischen dem Netzeingang (54) und der Maschine (52) in den Schutzleiter ein Bauelement (61) eingesetzt ist, welches im Normalbetrieb hochohmige Eigenschaft und bei Auftreffen des Schutzleiters (PE') der Maschine (52) auf eine Fremdphase oder im Falle eines Defektes der Maschine (52) niederohmig wird.

8. Schaltung nach Anspruch 7,
**dadurch gekennzeichnet,**
**daß** das Bauelement (61) durch einen Varistor gebildet ist.

9. Schaltung nach Anspruch 8,
**dadurch gekennzeichnet,**
**daß** der Sensoreingang (2) zwischen den Varistor (61) und den Schutzleiteranschluß (PE') der Maschine (52) geschaltet ist.

## Claims

1. Circuit for detecting a grounded metal part or the like, particularly for manually guided, electrically operated machinery such as drilling machines or the like, comprising a measuring amplifier (1) having inputs (4, 3) for the operating voltage and ground as well as an input (2) for an earth conductor potential,
including an operational amplifier (5) connected to the measuring amplifier (1), which generates an output signal which is applied to a charge pump (6) for voltage limitation, when a grounded metal part is detected, wherein the charge pump (6) is connected to a comparator (40) having an output which generates a control signal for interruption of the voltage supply of the machine when a grounded metal part is detected.

2. Circuit according to claim 1,
**characterized in**
**that** the output signal of the operational amplifier (1) is a periodic signal at means frequency.

3. Circuit according to claim 1 or 2,
**characterized in**
**that** the measuring amplifier (1) comprises means (10, 11) for limiting the input voltage.

4. Circuit according to claim 1 or 2,
**characterized in**
**that** the measuring amplifier (1) comprises means (12) for limiting the input voltage supplied via the sensor input (2).

5. Circuit according to one of the preceding claims,
**characterized in**
**that** the charge pump (6) is provided with means (32, 33) for rectifying the input signal supplied to the charge pump (6).

6. Circuit according to at least one of the preceding claims,
**characterized in**
**that** the output of the comparator (40) is connected to an earth leakage circuit breaker (53) which controls switching contacts (59) being provided between the machine (52) and the power input (54).

7. Circuit according to claim 6,
**characterized in**
**that** a component (61) is inserted into the ground wire (PE') between the power input (54) and the machine (52), whereas the component (61) has high impedance characteristics in normal operation and changes to low impedance when the ground wire (PE') of the machine (52) strikes upon an external phase or in the event of a defect of the machine (52).

8. Circuit according to claim 7,
**characterized in**
**that** the component (61) is formed by a varistor.

9. Circuit according to claim 8,
**characterized in**
**that** the sensor input (2) is connected between the varistor (61) and the ground wire contact (PE') of the machine (52).

## Revendications

1. Circuit de détection d'un élément métallique mis à la terre ou analogues, notamment pour des machines à commande manuelle et à actionnement électrique, telles que des perceuses ou analogues, avec un amplificateur de mesure (1), qui comporte des entrées (4, 3) pour la tension de fonctionnement et la masse, ainsi qu'une entrée (2) pour un potentiel de conducteur de protection,
avec un amplificateur opérationnel (5), qui est relié à l'amplificateur de mesure (1) qui, dans le cas d'une constatation de la présence d'un élément métallique mis à la terre, produit un signal de sortie qui est appliqué à une pompe à charge (6) pour limiter la tension,
la pompe à charge (6) étant reliée à un comparateur (40), dont la sortie fournit, dans le cas de la constatation de la présence d'un élément métallique mis à la terre, un signal de commande pour l'interruption de la tension d'alimentation de la machine.

2. Circuit selon la revendication 1,
**caractérisé en ce que** le signal de sortie de l'amplificateur opérationnel (1) est un signal périodique, à la fréquence du réseau.

3. Circuit selon la revendication 1 ou 2,
**caractérisé en ce que** l'amplificateur de mesure (1) présente un dispositif (10, 11) servant à limiter la tension d'entrée.

4. Circuit selon la revendication 1 ou 2,
**caractérisé en ce que** l'amplificateur de mesure (1) présente un dispositif (12) servant à limiter la tension d'entrée, appliquée par l'intermédiaire de l'entrée de détection (2).

5. Circuit selon l'une des revendications précédentes,
**caractérisé en ce que** la pompe à charge (6) est pourvue d'un dispositif (32, 33) pour le redressement du signal d'entrée fourni à la pompe à charge (6).

6. Circuit selon au moins l'une des revendications précédentes,
**caractérisé en ce que** la sortie du comparateur (40) est reliée à un disjoncteur de protection pour courant de défaut (53), qui commande les contacts de commutation (59), situés entre la machine (52) et l'entrée du réseau (54).

7. Circuit selon la revendication 6,
**caractérisé en ce qu'**un élément (61) est disposé entre l'entrée du réseau (54) et la machine (52), cet élément ayant, en fonctionnement normal, une propriété de valeur ohmique élevée tandis que, lorsque le conducteur de protection (PE') de la machine (52) rencontre une phase extérieure, ou bien dans le cas d'une défaillance de la machine (52), il prend une valeur ohmique faible.

8. Circuit selon la revendication 7,
**caractérisé en ce que** l'élément (61) est constitué par une varistance.

9. Circuit selon la revendication 8,
**caractérisé en ce que** l'entrée de détection (2) est montée entre la varistance (61) et la connexion du conducteur de protection (PE') de la machine (52).
